# EUROPEAN PATENT APPLICATION

(11) **EP 2 113 497 A2**
(43) Date of publication of application: **04.11.2009**
(21) Application number: 09006011.2
(22) Date of filing: 30.04.2009
(51) Int. Cl.: C04B 35/83, C04B 35/524, C04B 41/45

(54) **High purity carbon fiberreinforced carbon composite for semiconductor manufacturing apparatus and method for producing the same**

(30) Priority: 30.04.2008 JP 2008119400
(71) Applicant: IBIDEN CO., LTD., Ogaki-shi, Gifu 503-0695 (JP)
(72) Inventor: Kato, Hideki, Ogaki Gifu (JP); Yasuda, Masahiro, Ogaki Gifu (JP)
(74) Representative: HOFFMANN EITLE

(57) **Abstract**

A high-purity carbon fiber-reinforced carbon composite for a semiconductor manufacturing apparatus is provided. The carbon composite includes: a matrix having a crystalline carbon-based powder, a glassy carbon; and a carbon fiber. The sulfur content in the carbon composite is 5 ppm by mass or less. Additionally, a method for producing the carbon composite is provided. The method includes refining a carbon fiber-reinforced carbon composite comprising: a matrix including a crystalline carbon-based powder and glassy carbon; and a carbon fiber. The refining includes: heating the carbon composite at 1,800 to 2,400 °C after vacuuming in a refining furnace; and alternately repeating a first step of introducing a halogen-based gas to 50 kPa or more, and a second step of performing vacuuming to 20 kPa or less.

## Description

### BACKGROUND OF THE INVENTION

### Field of the Invention

The present invention relates to a high-purity carbon fiber-reinforced carbon composite (C/C composite) used in an apparatus for manufacturing a semiconductor of silicon, SiC, a compound or the like.

### Description of the Related Art

A carbon fiber-reinforced carbon composite (hereinafter also referred to as a C/C composite) has the advantage of being light in weight, strong and able to easily grow in size. Therefore, it is widely used for silicon single crystal pulling-up apparatus, silicon polycrystal manufacturing apparatus, semiconductor manufacturing apparatus and the like.

In these cases, high-purity C/C composites refined with a halogen gas are used, in order to suppress contamination of silicon single crystals and the like with impurities such as metals.

A C/C composite is obtained by shaping carbon fibers or graphite fibers into a formed article by a method such as filament winding, impregnating the formed article with a binder containing a thermosetting resin such as a phenol resin, and curing and burning it. The obtained C/C composite is refined with a halogen gas, and thereafter used for the above-mentioned application (see JP-A-10-152391 and JP-A-2002-173392). The thermosetting resin used in impregnation becomes amorphous glassy carbon in the course of burning.

However, according to the related-art production method, sufficient strength cannot be obtained through a single impregnation step, so that the impregnation, curing and burning processes are repeated several times, thereby obtaining sufficient strength.

Further, the related-art C/C composite is low in gas permeability. The reason for this is as follows. A matrix of the C/C composite is mainly composed of amorphous glassy carbon, which is gas impermeable. Moreover, the impregnation process is repeated several times, so that continuous pores leading from a surface layer of the composite to its inside become extremely thin, or the pores become partially closed and thus no longer lead to the outside of the composite. Therefore, it is difficult to remove an impurity mainly composed of metal elements from the inside of the composite by the related-art refining method of heating the composite in the halogen gas.

In order to solve the above problem, research has been done to determine whether it would be possible to use a crystalline carbon-based powder material such as coke or graphite as a third component of the C/C composite so as to decrease the proportion of the glassy carbon in a product (see JP-A-7-48191 and WO2006/003774).

Such a three-component C/C composite includes: a small amount of the glassy carbon, which is originally gas-impermeable and from the inside of which impurities are hard to remove; high-density crystalline carbon-based material; low-density carbon fibers; and low-density glassy carbon for binding these, which is obtained by carbonizing a phenol resin or the like. Accordingly, the three-component C/C composite can have more voids on the inside than the related-art two-component C/C composite that contain the low-density carbon fibers and the low-density glassy carbon, even when the three-component C/C composite has the same bulk density as the related-art two-component C/C composite. Therefore, a refining gas (halogen gas) can penetrate into the inside of the composite, thereby making it easy to remove impurities, especially those containing metal elements.

Table 1 shows the physical properties of one example of a three-component C/C composite and one example of a two-component C/C composite. Further, Fig. 1 shows a graph of the pore distribution of a three-component C/C composite measured by a mercury penetration method using a porosimeter manufactured by Thermo Finnigan, Fig. 2 shows a graph of the pore distribution of a two-component C/C composite, Fig. 3 shows a graph of the cumulative pore distribution of the three-component C/C composite and the related-art two-component C/C composite, Fig. 4 shows a graph of the X-ray diffraction measurement of the three-component C/C composite, and Fig. 5 shows a graph of the X-ray diffraction measurement of the two-component C/C composite.

**[Table 1]**

| | Three-Component C/C Composite | Two-Component C/C Composite |
|---|---|---|
| True density (g/cm³) | 2.24 | 1.86 |
| Bulk Density (g/cm³) | 1.57 | 1.65 |
| Porosity (%) | 24.5 | 10.9 |
| X-Ray Diffraction Measurement (002) Half-Value Width (°) | 0.4 | 0.6 |
| Tensile Strength in Fiber Orientation Direction (MPa) | 87 | 121 |

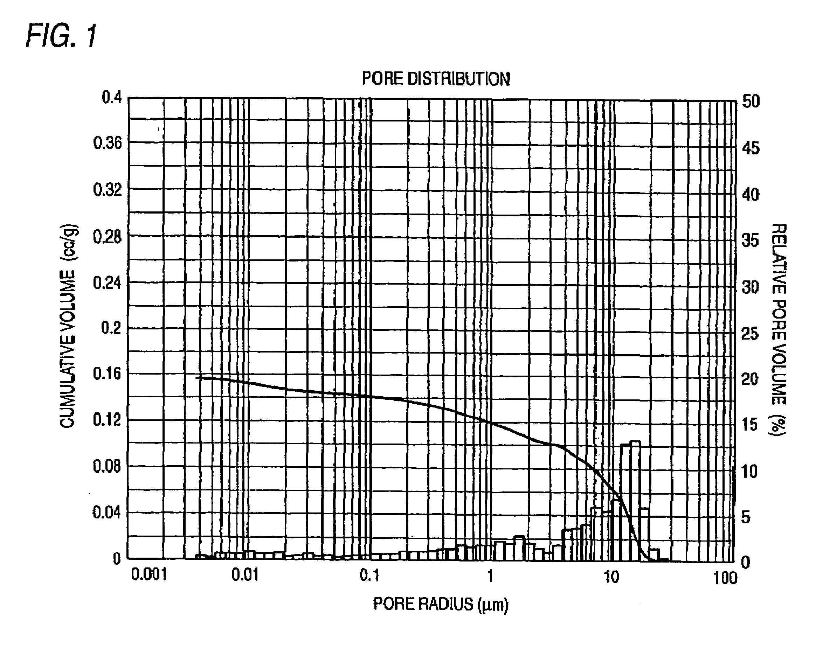

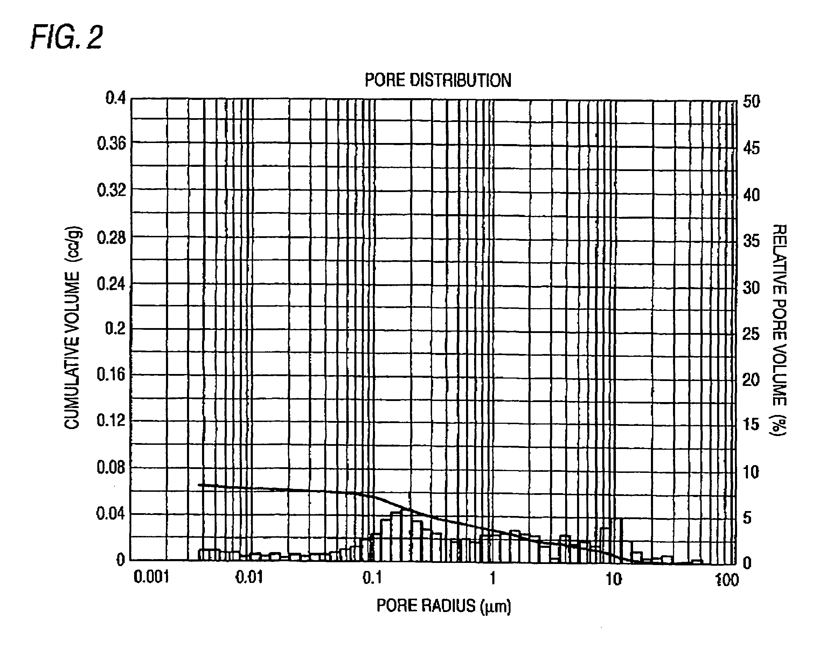

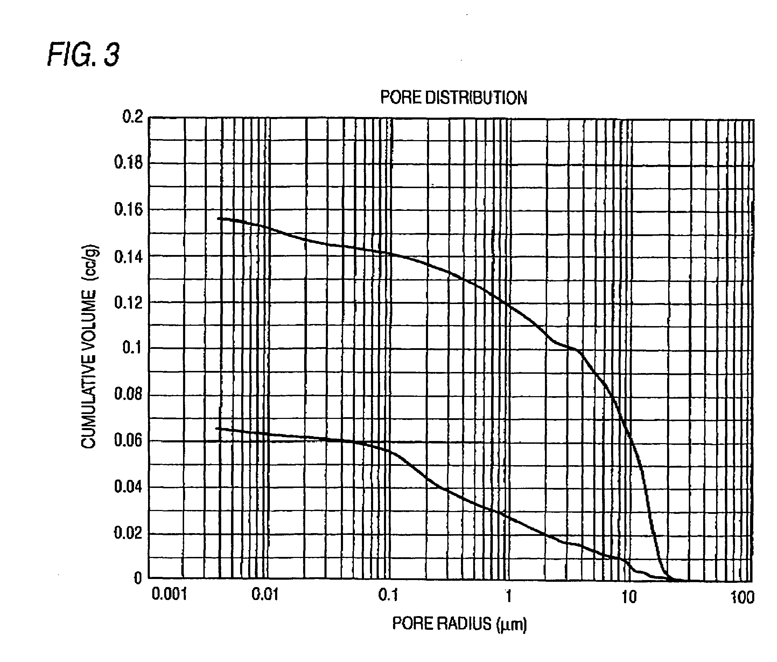

Fig. 1 reveals that in the three-component system, pores must have a radius of about 10 µm. Fig. 2 reveals that in the two-component system, pores are widely distributed between 0.1 and 10 µm. Fig. 3 reveals that the three-component system has more pores compared to the two-component system. Further, Table 1 reveals that the three-component system is more porous than the two-component system because of its high true density, although the three-component system and the two-component system are practically equal in bulk density.

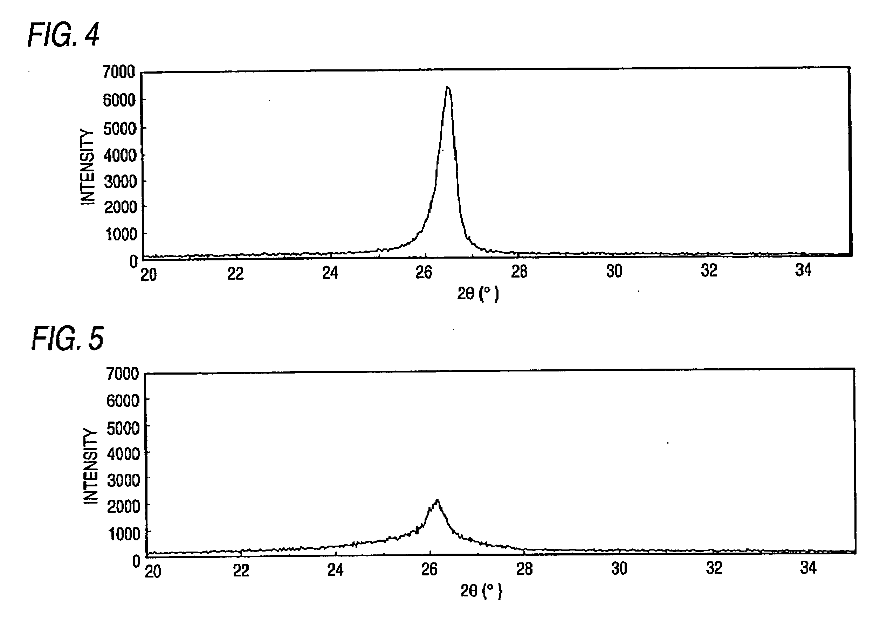

Both Figs. 4 and 5 and Table 1 show that the three-component C/C composite has a higher crystallinity compared to the two-component C/C composite since the peak intensity on the 002 plane of the three-component C/C composite is sharp. In other words, it can be said that the true density of the three-component C/C composite is higher than that of the two-component C/C composite.

Table 1 reveals that the tensile strength in the fiber-orientation direction of the three-component system even exceeds 50 MPa. That is, the strength of the three-component system is sufficient for its use as a member of a semiconductor manufacturing apparatus.

Further, the three-component C/C composite has few binders such as a phenol resin which produces a large amount of volatile matter in raw materials, so that the high-density C/C composite can be obtained after a single impregnation step without repeated impregnation. It would therefore be advantageous to substantially simplify the processes as compared to those of the two-component system.

However, even when using the three-component C/C composite, from which it is conceivable that the metal impurities can be easily removed , there still is a problem with respect to purity. High-purity silicon cannot be obtained when it is used for a semiconductor manufacturing apparatus such as a silicon single crystal pulling-up apparatus. When the three-component C/C composite comes into contact with a copper alloy, silver or the like, this leads to a problem when the copper alloy, silver or the like corrodes.

### SUMMARY OF THE INVENTION

The present invention has been made in view of the above circumstances, and an object thereof is to provide a carbon fiber-reinforced carbon composite having high purity and high strength.

After intensive studies, the inventors of the present application have found that such problems are caused by sulfur contained in the three-component C/C composite.

Accordingly, an exemplary embodiment of the present invention provides the following high-purity carbon fiber-reinforced carbon composite and method for producing the same.

[1] A high-purity carbon fiber-reinforced carbon composite for a semiconductor manufacturing apparatus, the carbon composite comprising: a matrix including a crystalline carbon-based powder, glassy carbon, and a carbon fiber, wherein the sulfur content is 5 ppm by mass or less.

[2] The high-purity carbon fiber-reinforced carbon composite for a semiconductor manufacturing apparatus described in the above [1], may have a true density from 2.0 to 2.265 g/cm³, as measured with a pycnometer using a helium gas; a bulk density from 1.40 to 1.80 g/cm³; a half-value width of 0.5° or less on a 002 plane determined by X-ray diffraction measurement; and a tensile strength of 50 MPa or more in a fiber orientation direction.

[3] The high-purity carbon fiber-reinforced carbon composite for a semiconductor manufacturing apparatus described in the above [1] or [2] may have a porosity from 10 to 35%, as measured by a mercury penetration method.

[4] The high-purity carbon fiber-reinforced carbon composite for a semiconductor manufacturing apparatus described in the above [1] or [2] may have a sulfur content of 4 ppm by mass or less.

[5] A method for producing a high-purity carbon fiber-reinforced carbon composite for a semiconductor manufacturing apparatus, the method comprising; refining a carbon fiber-reinforced carbon composite comprising: a matrix including a crystalline carbon-based powder, glassy carbon and a carbon fiber, the refining process comprising the steps of heating the carbon composite at 1,800 to 2,400 °C after vacuuming in a refining furnace and alternately repeating a first step of introducing a halogen-based gas to 50 kPa or more, and a second step of vacuuming to 20 kPa or less.

[6] In the method described in the above [5], the refining process further comprises hydrogen baking the carbon composite between the first step and the second step.

As configured above, the three-component C/C composite in which the metal elements are easily removed and the production processes are decreased can even decrease the pollution of silicon or corrosion of the copper alloy or silver contacting therewith in the silicon single crystal pulling-up apparatus.

### BRIEF DESCRIPTION OF THE DRAWING

In the accompanying drawings:

Fig. 1 is a graph showing the pore distribution of a three-component C/C composite;

Fig. 2 is a graph showing the pore distribution of a two-component C/C composite;

Fig. 3 is a graph showing the cumulative pore distribution of the three-component C/C composite and the related-art two-component C/C composite;

Fig. 4 is a graph showing the X-ray diffraction measurement of the three-component C/C composite;

Fig. 5 is a graph showing the X-ray diffraction measurement of the two-component C/C composite; and

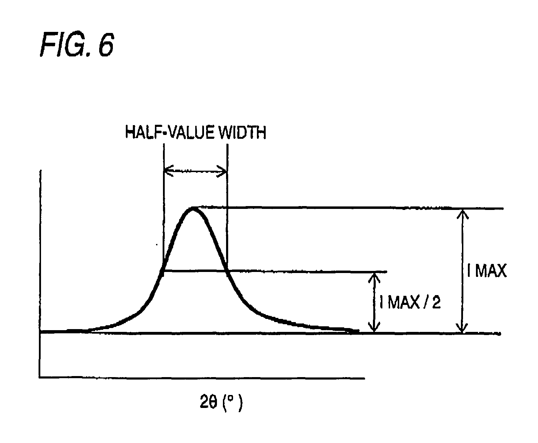

Fig. 6 is a conceptual diagram showing the half-value width.

### DETAILED DESCRIPTION

<Carbon Fiber-Reinforced Carbon Composite (C/C Composite)>

The carbon fibers that can be used for the high-purity carbon fiberreinforced carbon composite according to an exemplary embodiment of the present invention are a pitch-based or PAN-based carbon fiber or a further heat treated graphite fiber. Of these, the advantages of the PAN-based carbon fiber are its adhesion with a binder resin and its adequate flexibility, which easily adjusts to some deformation. Therefore, even when external force is applied to deform it, the C/C composite is hardly cracked or crushed.

The high-purity carbon fiber-reinforced carbon composite according to the exemplary embodiment further comprises a matrix including a crystalline carbon-based powder and glassy carbon.

The crystalline carbon-based powder, which is one of the constituents of the matrix, is obtained by carbonizing an easily crystallizable carbon-based material by heat treatment. Petroleum-derived or coal-derived coke or graphite can be used for the easily crystallizable carbon-based material. The crystalline carbon-based powder does not necessarily have to be crystalline as a raw material (namely, the easily crystallizable carbon-based material), and includes a carbonaceous powder convertible to a crystalline carbonaceous powder by burning, such as green coke and mesocarbon. Of these, it is particularly preferred to use a coke in which crystallization has not sufficiently proceeded, because such coke has many functional groups at terminals of aromatic rings, so that it exhibits good adhesion with the binder resin. Additionally, it contracts more after heat treatment than it decreases in weight, so that a C/C composite with high density and high strength can be obtained. The content of the crystalline carbon-based powder is from 20 to 75% by mass, and preferably from 30 to 50% by mass, based on the total mass of the carbon fiber, crystalline carbon-based powder and glassy carbon. When its content is 20% by mass or more, the metal impurities do not become difficult to refine, and it does not substantially become the two-component system. Accordingly, the strength needed to withstand practical application is achieved without having to repeat the impregnation process several times. When its content is 75% by mass or less, the content of the carbon fibers does not decrease, so that the strength needed to withstand practical application is achieved. The content of the crystalline carbon-based powder can be controlled by adjusting the content of the easily crystallizable carbon-based material as a raw material to the above-mentioned range based on the total mass of the carbon fiber, the easily crystallizable carbon-based material and the binder resin.

The glassy carbon, which is one of the constituents of the matrix, is obtained by carbonizing the binder resin through heat treatment. A thermosetting resin having a high carbonization yield such as a novolac or resol phenol resin, a furan resin, a polyimide resin or a cyanate ester compound can be used for the binder resin. Of these, the phenol resin is preferred. The content of the glassy carbon is preferably from 10 to 40% by mass, and more preferably from 15 to 35% by mass, based on the total mass of the carbon fiber, the crystalline carbon-based powder and the glassy carbon. When the content is within the range of 10 to 40% by mass, sufficient strength can be achieved without having to repeat the impregnation process. The content of the glassy carbon can be controlled by adjusting the content of the binder resin as a raw material to the above-mentioned range based on the total mass of the carbon fibers, the easily crystallizable carbon-based material and the binder resin.

In the exemplary embodiment, an additive such as silicon, SiC or a metal can be added to the high-purity carbon fiber-reinforced carbon composite in addition to the above.

According to the exemplary embodiment of the present invention, the high-purity carbon fiber-reinforced carbon composite preferably has a true density from 2.0 to 2.265 g/cm³, and more preferably from 2.05 to 2.265 g/cm³. When its true density is kept within the above-mentioned range, the continuous pores leading to the outside of the material can easily form, so that the impurities present in the C/C composite can be easily removed with a refining gas. The true density of the glassy carbon obtained by carbonizing the binder resin is approximately from 1.4 to 1.6 g/cm³, and the true density of the carbon fiber is from 1.5 to 2.0 g/cm³. Accordingly, the true density of the related-art two-component C/C composite obtained therefrom can be roughly calculated to range from at most 1.4 to 2.0 g/cm³. Compared to this, the easily crystallizable carbon-based material such as coke or graphite, which has a true density of 2.10 to 2.265 g/cm³ after heat treatment, is used in the three-component C/C composite according to an exemplary embodiment of the present invention, and the content of the binder resin and the like, which is lower in true density after heat treatment, is small by the amount. The true density of the whole C/C composite therefore exhibits a value as high as 2.0 to 2.265 g/cm³ as described above.

The true density can be measured, for example, with a commercially available true density meter (Penta-Pyenometer manufactured by Yuasa Ionics Inc.) or the like.

In the carbon fiber-reinforced carbon composite according to an exemplary embodiment of the present invention, the bulk density is preferably from 1.40 to 1.80 g/cm³, and more preferably from 1.45 to 1.70 g/cm³. When the bulk density is within the above-mentioned range, sufficient strength can be obtained, and the continuous pores leading to the outside of the material are easily formed, so that the impurities present in the C/C composite are easily removed with a refining gas.

The bulk density can be measured, for example, by dividing the mass of the carbon composite by the volume of the carbon composite obtained by dimension measurement.

Further, in the high-purity carbon fiber-reinforced carbon composite according to an exemplary embodiment of the present invention, a half-value width on the 002 plane (26.0 degree) in X-ray diffraction measurement is preferably 0.5° or less, and more preferably 0.4° or less. The crystallinity of the carbon material can be measured by X-ray diffraction measurement. As shown in Fig. 6, the half-value width means the width of strength at a height of one-half the peak height from the background. A lower half-value width shows a broadening of the crystal face and expresses higher crystallinity. The X-ray diffraction measurement can be performed using a pulverized powder of the carbon fiber-reinforced carbon composite as a sample and using, for example, an X-ray diffractometer with Cu Kα radiation.

The crystallinity of the glassy carbon obtained by carbonizing the carbon fiber, the binder resin or the like by heat treatment or the like is low, and the crystallinity of the crystalline carbon-based powder obtained by heat treating coke, graphite or the like (the easily crystallizable carbon-based material) is high. The C/C composite according to an exemplary embodiment of the present invention includes a large amount of the crystalline carbon-based powder, and a small amount of binder resin and glassy carbon. Accordingly, the half-value width on the 002 plane becomes a value within the above-mentioned range. On the other hand, in the related-art two-component C/C composite using no easily crystallizable carbon-based material and using the carbon fiber and the phenol resin as the main raw material, the half-value width on the 002 plane is deduced to become 0.5° or more.

The true density is from 2.0 to 2.265 g/cm³, and the bulk density is from 1.40 to 1.80 g/cm³. This means that the C/C composite exhibits sufficient strength to withstand practical application since the theoretical value of its porosity ranges from about 10 to about 38%. Further, the half-value width on the 002 plane (26.0 degree) in X-ray diffraction measurement is 0.5° or less. This means that it exhibits high crystallinity. Accordingly, the continuous pores are easily formed in the C/C composite, so that the gas used to achieve high refinement can easily penetrate to the inside. It is therefore possible to remove the impurities present in the C/C composite with the refining gas while sufficiently securing the strength of the C/C composite.

Then, the high-purity carbon fiber-reinforced carbon composite according to an exemplary embodiment of the present invention exhibits a porosity that preferably ranges from 10 to 35%, and more preferably from 20 to 35%. The porosity can be measured by the mercury penetration method, for example, using a porosimeter manufactured by Thermo Finnigan. When the porosity measured by the mercury penetration method is within such a range, a sufficient number of continuous pores are formed.

Further, the tensile strength in a fiber orientation direction of the high-purity carbon fiber-reinforced carbon composite according to an exemplary embodiment of the present invention is preferably 50 MPa or more. When the tensile strength is 50 MPa or more, the strength necessary for a member of a semiconductor manufacturing apparatus can be obtained.

In the high-purity carbon fiber-reinforced carbon composite according to an exemplary embodiment of the present invention, the sulfur content is 5 ppm by mass or less, and preferably 4 ppm by mass or less. The probability that sulfur or a sulfur compound will be diffused or released from the member when used over the years at high temperatures exponentially increases with an increase in sulfur content. Therefore, for example, when the sulfur content is 10 ppm by mass, the diffusion and release of sulfur or the sulfur compound usually becomes not negligible before the member reaches the end of its lifetime. In this respect, when the sulfur content can be suppressed to about 5 ppm by mass, the time when the diffusion and release of sulfur or a sulfur compound appears approximately coincides with the time when the member reaches the end of its lifetime. For this reason, adjustment of the sulfur content to 5 ppm by mass or less ensures that the member is hardly affected by the diffusion and release of sulfur or the sulfur compound until the member reaches the end of its lifetime. Accordingly, when the sulfur content is 5 ppm by mass or less, a high purity product can be obtained, and no corrosion problems arise at points of contact with silver or copper alloy. Incidentally, there is no lower limit value for the sulfur content; the sulfur content is preferably as small as possible and most preferably 0 ppm by mass. The sulfur content can be measured using a sample having a disk shape with a diameter of 20 mm and a thickness of 1 mm by Glow-Discharge Mass Spectrometry (GDMS).

<Production Method>

The high-purity C/C composite according to an exemplary embodiment of the present invention can be produced by the following method.

A method according to an exemplary embodiment of the present inventionhigh-purity C/C composite can be obtained by refining the three-component C/C composite comprising a carbon fiber, a crystalline carbon-based powder and glassy carbon, which has been prepared using a carbon fiber, easily crystallizable carbon-based material and binder resin as raw materials. A related-art three-component C/C composite can be utilized for the three-component C/C composite. For example, the three-component C/C composite can be produced by a method described in JP-A-07-48191 or WO2006-3774.

The easily crystallizable carbon-based material used in the high-purity carbon fiber-reinforced carbon composite according to an exemplary embodiment of the present invention can be petroleum-derived coke to be carbonized in a liquid phase or coal-derived coke, graphite obtained by carbonizing these cokes, or the like. The raw material used to obtain the easily crystallizable carbon-based material is a mineral resource formed from the conversion of animal or plant plankton, so that it contains high concentrations of amino acids such as cysteine, methionine, and sulfur of biologic origin. The refining treatment process is performed mainly to remove the sulfur.

In the refining treatment process, the three-component C/C composite is first vacuumed in a refining furnace, and then heated at 1,800 to 2,400°C, preferably at 1,900 to 2,300°C. At 1,800°C or higher, removal of other metal elements does not become difficult, and at 2,400°C or lower, there is no fear that the crystallinity of the carbon fibers will increase to such an extent that it will become brittle. Vacuuming is preferably performed to 10 kPa or less. Further, the retention time after heating is preferably from 0.1 to 4 hours.

As a first step, a halogen-based gas is introduced into the refining furnace with the composite to 50 kPa or more. This is followed by a second, vacuuming step, which is carried out to 20 kPa or less. The composite is then again subjected to the first step, the second step, the first step and the second step, at which point the treatment is terminated. This ensures that the metal impurities contained in the C/C composite will chemically change to metal halides which are easily volatilized at high temperatures, and flow out from the inside of the pores to the outside of the material. Simultaneously, impurities such as sulfur matter can be flowed out together to the outside of the pores as a sulfur-based gas. Examples of halogen-based gases that can be used for this are chlorine gas or fluorine gas, an organic halogen-based gas such as CF₄ or CHCl₃, or the like. Chlorine gas is particularly preferred.

Introduction of the halogen-based gas is performed up to 50 kPa, and preferably up to 60 kPa. This is because the metal impurities can be sufficiently removed.

Vacuuming is performed up to a degree of vacuum of 20 kPa or less, more preferably 10 kPa or less. This is because the impurities in the pores can be efficiently removed by performing vacuuming at a high degree of vacuum.

In the production method according to an exemplary embodiment of the present invention, refinement is not performed at a constant pressure. However, the introduction of the halogen-based gas (the first step) and vacuuming (the second step) are alternately repeated a number of times, preferably 4 times or more. This is because repeating the above-mentioned steps can efficiently remove the impurity-containing gas generated in the inside of the pores to the outside of the system.

In the refining treatment process in the production method according to an exemplary embodiment of the present invention, a hydrogen baking step may be added between the introduction of the halogen-based gas (the first step) and vacuuming (the second step). Sulfur can easily be removed by baking it with hydrogen because it forms the compound (H₂S). Furthermore, the impurity gas generated in the vacuuming step is easily removed, similarly to the above.

[Examples]

<Production of High-Purity Carbon Fiber-Reinforced Carbon Composite>

(Example 1)

Coal-derived green coke having an average particle size of 2 µm was used as an easily crystallizable carbon-based material, a PAN-based chopped fiber having an average diameter of 7 µm and a length of 5 mm was used as a carbon fiber, and a resol-based phenol resin was used as a binder resin. Then, 30% by mass of the easily crystallizable carbon-based material, 45% by mass of the carbon fiber and 25% by mass of the binder resin were mixed using a mixer, and pressed using a mold having a 100×100 mm cavity at 20 MPa and 90°C for 15 minutes to perform cursing.

The resulting molded article was further treated at 150°C for 30 minutes to completely cure it, and then burned under a reducing atmosphere (hydrocarbon gas) up to 900°C at a rate of temperature increase of 4°C/hour. Thereafter, it was burned in a subsequent high-temperature treating furnace under a nitrogen atmosphere up to 2,000°C at a rate of temperature increase of 50°C/hour. The C/C composite thus obtained was processed to a size of 70×70×20 mm. Incidentally, the fiber therein is biaxially orientated in 70x70 directions.

The above-mentioned C/C composite was placed in a refining furnace, and vacuuming was performed to 20 kPa and heated. When the temperature reached 2,100°C, chlorine gas was introduced until the pressure reached 60 kPa, and this state was retained for 1 minute (the first step). Vacuuming was performed again until the pressure reached 20 kPa (the second step). When the pressure reached 20 kPa, the process continued with the above-mentioned first step. Thus, the first step and the second step were alternately repeated three times. After the high refinement process was completed, the C/C composite was cooled, and then the pressure was recovered with nitrogen gas. Thereafter, the C/C composite was exposed to the atmosphere.

The following evaluations were performed on the obtained C/C composite. The results are shown in Table 2.
True density: measured by a pycnometer method using helium gas with a Pyenometer manufactured by Yuasa Ionics Inc.
Bulk density: calculated by dividing the mass by the volume obtained by dimension measurement.
Porosity: measured by a mercury penetration method using a porosimeter manufactured by Thermo Finnigan (the porosity is obtained by multiplying the pore amount (cc/g) by the bulk density).
X-ray diffraction measurement: the (002) diffraction line of the C/C composite was measured using an X-ray diffractometer using Cu Kα radiation.
Tensile strength in a fiber orientation direction: measured by attaching a holder for a tensile test to Autograph AG-IS (5 kN) manufactured by Shimadzu Corporation.

<Impurity Analysis>

Sulfur analysis and chlorine analysis were performed on the sample of Example 1 and a commercially available three-component C/C composite, which bad not undergone refining treatment (Comparative Example 1). The results thereof are shown in Table 2.

**[Table 2]**

| | Example 1 | Comparative Example 1 |
|---|---|---|
| Sulfur Content (ppm by mass) | 3.5 | 6.5 |
| Chlorine Content (ppm by mass) | 0.61 | 0.42 |
| True density (g/cm³) | 2.24 | 2.24 |
| Bulk Density (g/cm³) | 1.57 | 1.57 |
| Porosity (%) | 24.8 | 24.5 |
| X-Ray Diffraction Measurement (002) Half-Value Width (°) | 0.4 | 0.4 |
| Tensile Strength in Fiber Orientation Direction (MPa) | 92 | 87 |

As shown in Table 2, the sulfur content of the C/C composite of Example 1 was found to have been decreased by the refining treatment according to an exemplary embodiment of the present invention. Further, the chlorine content, the true density, the bulk density, the porosity, the half-value width on the 002 plane and the tensile strength in a fiber orientation direction were found to scarcely vary, and there was little left of the chlorine gas used for the refinement. That is, the characteristics were found to have changed very little. In the case of chlorine, its content has been somewhat increased by the high refinement, but it is far less than 5 ppm by mass. If the content of chlorine is 5 ppm by mass or more, its influence will increase over the years through use. Accordingly, the influence of chlorine is negligible.

## Claims

1. A carbon fiber-reinforced carbon composite, the carbon composite comprising:
a matrix including a crystalline carbon-based powder, and glassy carbon; and
a carbon fiber,
wherein the content of sulfur is 5 ppm by mass or less.

2. The carbon composite according to claim 1, which has:
a true density from 2.0 to 2.265 g/cm³, measured with a pycnometer using a helium gas;
a bulk density from 1.40 to 1.80 g/cm³;
a half value width of 0.5° or less on a 002 plane determined by X-ray diffraction measurement; and
a tensile strength of 50 MPa or more in a fiber orientation direction.

3. The carbon composite according to claim 1 or 2,
wherein a porosity measured by a mercury penetration method is from 10 to 35%.

4. The carbon composite according to claim 1 or 2,
wherein the content of sulfur is 4 ppm by mass or less.

5. A semiconductor manufacturing apparatus comprising a carbon fiber-reinforced carbon composite as defined in one of more of claims 1 to 4.

6. A method for producing a carbon fiber-reinforced carbon composite, the method comprising:
refining a carbon fiber-reinforced carbon composite comprising: a matrix including a crystalline carbon-based powder and glassy carbon; and a carbon fiber,
the refining comprising:
heating the carbon composite at 1,800 to 2,400 °C after vacuuming in a refining furnace; and
alternately repeating a first step of introducing a halogen-based gas to 50 kPa or more, and a second step of perform vacuuming to 20 kPa or less.

7. The method according to claim 6,
wherein the refining further comprises hydrogen baking of the carbon composite between the first step and the second step.
